# EUROPEAN PATENT SPECIFICATION

(11) **EP 4 417 989 B1**
(45) Date of publication and mention of the grant of the patent: **23.07.2025**
(21) Application number: 23315034.1
(22) Date of filing: 17.02.2023
(51) Int. Cl.: G01R 33/09, G01R 33/00, H01F 10/32

(54) **MAGNETORESISTIVE ELEMENT HAVING AN OUT-OF-PLANE SENSITIVITY AXIS AND HAVING REDUCED HYSTERESIS AND INCREASED WORKING FIELD RANGE**
MAGNETORESISTIVES ELEMENT MIT EINER AUSSER-EBENEN-EMPFINDLICHKEITSACHSE UND MIT VERRINGERTER HYSTERESE UND ERHÖHTEM ARBEITSFELDBEREICH
ELÉMENT MAGNÉTORÉSISTIF À AXE DE SENSIBILITÉ HORS PLAN ET À HYSTÉRÉSIS RÉDUITE ET À PLAGE DE CHAMP DE TRAVAIL AUGMENTÉE

(43) Date of publication of application: 21.08.2024
(73) Proprietor: Allegro MicroSystems, LLC, Manchester, NH 03103 (US)
(72) Inventor: Dounia, Salim, 38000 Grenoble (FR); Timopheev, Andrey, 38450 Vif (FR); Strelkov, Nikita, 38240 Meylan (FR)
(74) Representative: South, Nicholas Geoffrey

(56) References cited:
- EP-A1- 4 012 431
- CN-U- 203 932 116
- KR-A- 20090 063 625
- US-A1- 2017 236 570

## Description

### Technical domain

The present invention concerns a magnetoresistive element comprising a sense layer, for measuring an external magnetic field along an axis substantially perpendicular to the plane of the sense layer.

### Related art

Magnetic sensors are widely used in cell phones and other mobile devices as electronic compass. For a two-dimensional external magnetic field in an X-Y plane, measurement of the X and Y components of the external magnetic field within the plane may be implemented by using two orthogonal sensors. For the measurement on the external magnetic field in a Z-axis direction, a separate single-axis planar magnetoresistive sensor arranged perpendicular to a two-axis planar sensor can be used. This solution requires assembling two different sensors, the X-Y two-axis magnetoresistive sensor and the Z-axis magnetoresistive sensor.

The external magnetic field in a Z-axis direction canal can further be measured by using a flux guide to convert an external magnetic field from the Z-axis direction into magnetic field components in the X- and Y-axis directions. For example, document US2012206137 discloses a single-chip three-axis AMR sensor, which implements measurement of an external magnetic field in the Z-axis direction by placing a flux guide above in-plane sensors. In such solution, the external magnetic field in the Z-axis direction is not fully converted into the X- and Y-axis directions. Moreover, such sensor design needs to use a specific algorithm for calculating the external magnetic field in the Z-axis direction, which makes the sensor design more complicated.

Another solution for measuring an external magnetic field in a Z-axis direction includes using magnetic materials with perpendicular magnetic anisotropy. For example, document US20130168787 discloses a magnetic sensor which measures a Z-axis component of an external magnetic field by using a perpendicular magnetic anisotropy material.

In the European Patent Application No. EP4012431, the present applicant discloses a magnetoresistive element for measuring a Z-axis component of an external magnetic field (or having an out-of-plane (OOP) sensitivity axis). The magnetoresistive element comprises a reference layer having a reference magnetization that is fixed and oriented substantially perpendicular to the plane of the reference layer. The magnetoresistive element further comprises a tunnel barrier layer and a sense layer having a free sense magnetization that has a vortex configuration in the absence of an external magnetic field. The vortex configuration is substantially parallel to the plane of the sense layer and has a vortex core magnetization direction along an out-of-plane axis substantially perpendicular to the plane of the sense layer.

However, the magnetoresistive element having an OOP sensitivity axis shows a non-negligible hysteresis that originates from the vortex core polarity switching which happens at high fields. The magnitude of the hysteresis and the vortex core switching field depends on the size of the vortex core, the geometry of the magnetoresistive element, and the magnetic material constituting the sensing layer. The magnitude of the hysteresis can reach 5 to 10 mT. The magnitude of the hysteresis can increase after the magnetoresistive element has been exposed to a high magnetic field (above the vortex core switching field). Consequently, the magnetoresistive element may have poor accuracy, reproducibility, and repeatability in operation.

Moreover, in the magnetoresistive element with the sense magnetization comprising a vortex configuration, different conductivity levels for different vortex core polarities may occur. In the case the reference layer comprises a synthetic antiferromagnet (SAF), the different core polarities will induce different conductivity levels. A larger or smaller conductivity of the magnetoresistive element is obtained when the vortex core and the reference magnetization are, respectively, in the same or opposite directions. A temperature increase results in a decrease in the core polarity switching field which, in turn, leads to a hysteresis appearing at smaller field exposure. This results in a reduced working range of the magnetoresistive element. In order to obtain a good accuracy and reproducibility of the electric response provided by the magnetoresistive element, the latter should be used in external magnetic fields that are below the vortex core switching field.

### Summary

The present disclosure concerns a magnetoresistive element for sensing an external magnetic field, comprising a tunnel barrier layer sandwiched between a ferromagnetic reference layer having a pinned reference magnetization, and a ferromagnetic sense layer having a sense magnetization that can be freely oriented in the external magnetic field. The reference, tunnel barrier, and sense layers are stacked perpendicular to a layer plane thereof. The reference magnetization is oriented substantially perpendicular to the layer plane, and the sense magnetization is oriented substantially parallel to the layer plane. At least a portion of the magnetoresistive element has an annular cross-section in the layer plane forming an interior part and an exterior part of said at least a portion, the interior part having an inner diameter and the exterior part having an outer diameter. Said at least a portion comprises the sense layer, the sense magnetization having a closed flux path configuration being orientable either in the clockwise or counterclockwise direction. The inner diameter is larger than 300 nm, and a difference between the inner and outer diameters is greater than 150 nm.

The present disclosure further concerns a magnetoresistive sensor device comprising a plurality of the magnetoresistive elements, wherein the magnetoresistive elements are electrically connected in series or in parallel.

The magnetoresistive element disclosed herein has no hysteresis. The magnetoresistive element can work in external magnetic fields above the vortex core switching field, thus has an extended magnetic field measuring working range.

### Short description of the drawings

Exemplar embodiments are disclosed in the description and illustrated by the drawings in which:
Fig. 1 illustrates a magnetoresistive element comprising a reference layer, a tunnel barrier layer, and a sense layer, and having an annular cross-section with an inner diameter and outer diameter, according to an embodiment;
Fig. 2 reports the magnetic sensitivity as a function of the ratio of the inner diameter to the outer diameter of the magnetoresistive element;
Figs. 3a-3c show different possible geometries of the magnetoresistive element, according to possible embodiments;
Fig. 4 shows the reference layer of the magnetoresistive element, according to an embodiment; and
Fig. 5 illustrates a magnetoresistive sensor device comprising a plurality of the magnetoresistive elements, according to an embodiment.

### Examples of embodiments

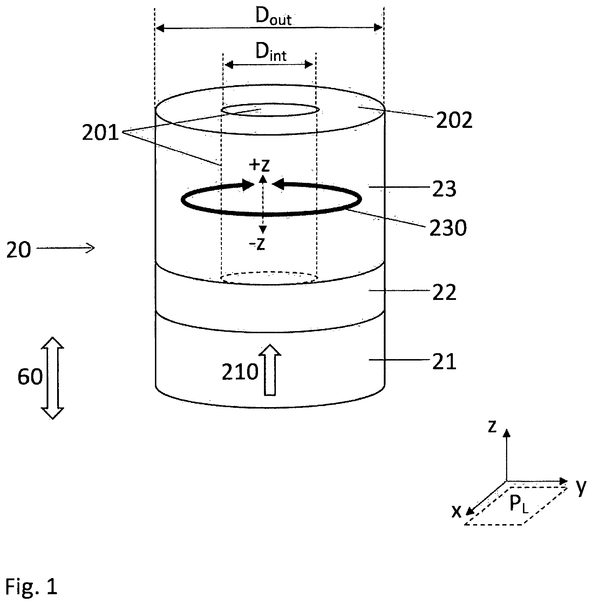

**Fig. 1** illustrates a magnetoresistive element 20, according to an embodiment. The magnetoresistive element 20 can comprise a magnetic tunnel junction. In particular, the magnetoresistive element 20 can comprise a reference layer 21 having a fixed reference magnetization 210, a sense layer 23 having a free sense magnetization 230 and a tunnel barrier layer 22 between the reference layer 21 and the sense layer 23. The sense magnetization 230 comprises a vortex configuration substantially parallel to the plane of the sense layer 23 in the absence of an external magnetic field 60.

As shown in Fig. 1, the reference layer 21, tunnel barrier layer 22 and sense layer 23 are stacked perpendicular to a layer plane P_{L} in which the layers 21, 22, 23 extend. Preferably, the reference layer 21 has a perpendicular magnetic anisotropy (PMA) such that the reference magnetization 210 is oriented substantially perpendicular to the layer plane P_{L}.

In an embodiment, at least a portion of the magnetoresistive element 20 has an annular cross-section in the layer plane P_{L}. The portion of the magnetoresistive element 20 thus has an interior part 201 and an exterior part 202. The interior part 201 can be void or comprise an insulating material. The magnetoresistive element 20 has an inner diameter Dᵢₙₜ and outer diameter Dₒᵤₜ. In one aspect, the portion comprises the sense layer 23. In this configuration, the tunnel barrier 22 and the reference layer 21 do not have an annular cross-section. The interior part 201 extending only along the sense layer 23 thickness is shown in Fig. 1 by the dashed line. Due to the annular shape of the sense layer 23, the sense magnetization 230 has a closed flux path configuration that is orientable either in the clockwise or counterclockwise direction. The closed flux path configuration of the sense magnetization 230 can be considered having a vortex configuration without vortex core.

Preferably, the sense magnetization 230 has a magnetic vector having a fixed orthogonal direction z that is substantially perpendicular to the layer plane P_{L}. Thus, the closed flux path configuration of the sense magnetization 230 can measure a Z-axis component of an external magnetic field, i.e., a component perpendicular to the layer plane P_{L}. In other words, the magnetoresistive element 20 has an OOP sensitivity axis. In normal operation of the magnetoresistive element 20, the magnetic vector of the sense magnetization 230 varies in a first orthogonal direction +z or a second orthogonal direction -z, opposed to the first orthogonal direction +z, depending on the direction and magnitude of the external magnetic field 60 that is substantially perpendicular to the layer plane P_{L}.

In one aspect, the portion of the magnetoresistive element 20 further comprises the sense layer 23 and the reference layer 23. In this configuration, the reference layer 21 does not have an annular cross-section. In another aspect, the portion of the magnetoresistive element 20 can comprise the sense layer 23, the tunnel barrier layer 22 and the reference layer 21.

The performances of the magnetoresistive element 20 depend on its geometry and more particularly, the inner diameter Dᵢₙₜ, the outer diameter Dₒᵤₜ, and the thickness of the magnetoresistive element 20.

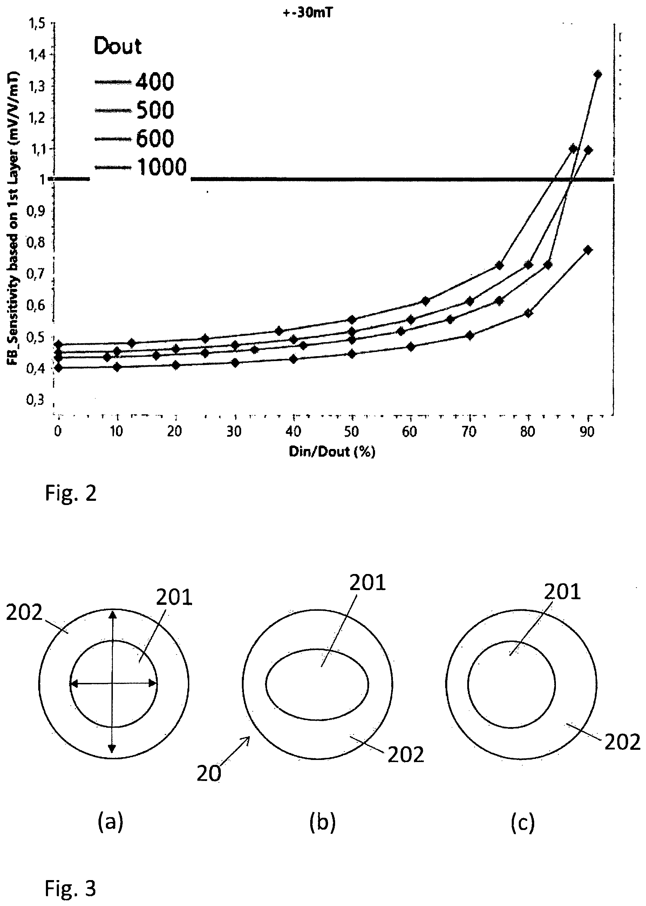

**Fig. 2** reports the field dependence of the magnetoresistance MRH, measured on the magnetoresistive element 20 for different inner and outer diameters Dᵢₙₜ, Dₒᵤₜ. More particularly, Fig. 2 reports the magnetic sensitivity as a function of the ratio of the inner diameter Dᵢₙₜ to the outer diameter Dₒᵤₜ. It can be seen that the magnetic sensitivity increases when the ratio of the inner diameter Dᵢₙₜ to the outer diameter Dₒᵤₜ is greater than 0.6.

Moreover, electrical short circuit can be observed in the magnetoresistive element 20 (between the reference layer and the sense layer) when the inner diameter Dᵢₙₜ is smaller than 300 nm.

It has been found that that optimum performances of the magnetoresistive element 20 are obtained when the inner diameter Dᵢₙₜ is larger than 300 nm, and a difference between the inner and outer diameters Dᵢₙₜ, Dₒᵤₜ is greater than 150 nm.

In one aspect, the outer diameter Dₒᵤₜ is between 500 nm and 5000 nm. The inner diameter Dᵢₙₜ is larger than 300 nm and the difference between the inner and outer diameters Dᵢₙₜ, Dₒᵤₜ is greater than 150 nm. The outer diameter Dₒᵤₜ equal or smaller the 5000 nm ensures that the sense magnetization 230 has a vortex configuration in the absence of an external magnetic field.

In another aspect, the aspect ratio of the thickness to diameter of the sense layer 23 can be between 0,005 and 2. The aspect ratio between 0,005 and 2 also ensures that the sense magnetization 230 has a vortex configuration in the absence of an external magnetic field.

In some embodiments, the resistance-area-product RA of the magnetoresistive element 20 can be higher than 50 ohm·µm².

Figs. 3a to 3c show different possible geometries of the magnetoresistive element 20 within the scope of the disclosure. More particularly, Fig. 3a shows the magnetoresistive element 20 where the interior part 201 has a substantially circular shape. Fig. 3a shows the magnetoresistive element 20 where the interior part 201 has an elliptical shape. In the geometries of Figs 3a and 3b, the interior part 201 is substantially concentric with the exterior part 202. Fig. 3c shows the magnetoresistive element 20 where the interior part 201 is nonconcentric with the exterior part 202.

The reference and sense layers 21, 23 can comprise, or be formed of, a ferromagnetic material such as a cobalt ("Co"), iron ("Fe") or nickel ("Ni") based alloy and preferentially a CoFe, NiFe or CoFeB based alloy. The sense layer 21 should have a thickness that is greater than 15 nm. The reference and sense layers 21, 23 can comprise a multilayer structure where each layer can include a ferromagnetic material such as a Co, Fe or Ni based alloy and preferentially a CoFe, NiFe or CoFeB based alloy, and nonmagnetic layers such as Ta, Ti, W, Ru, Ir.

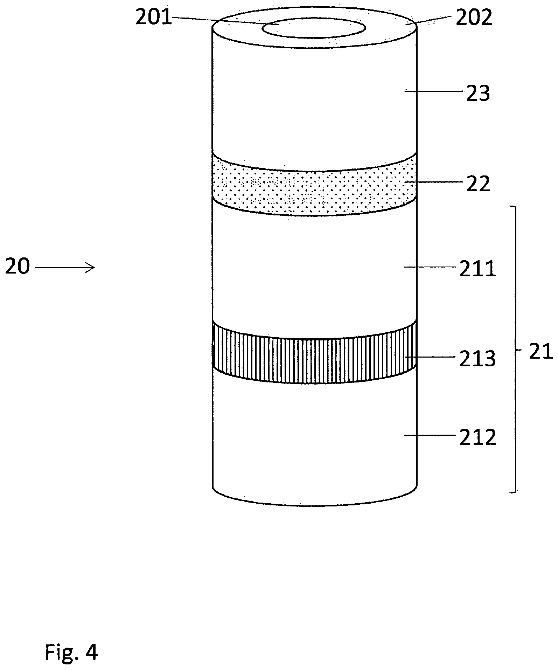

In a possible configuration of the magnetoresistive element 20 shown in **Fig. 4****,** the reference layer 21 can comprise a synthetic antiferromagnetic (SAF) structure including a first reference sublayer 211 in contact with the tunnel barrier layer 22 and a second reference sublayer 212 separated from the first reference sublayer 211 by a coupling layer 213, wherein the coupling layer 213 antiferromagnetically couple the first reference sublayer 211 to the second reference sublayer 212. Each of the first and second reference sublayer 211, 212 has a PMA such that a reference magnetization 210 is oriented substantially perpendicular to the plane of the first and second reference sublayer 211, 212 and in opposite directions.

In some embodiments not represented, the sense layer 23 comprises a SAF sense layer. In particular, the sense layer 23 comprises a first sense ferromagnetic layer having a first sense magnetization, and a second sense ferromagnetic layer having a second sense magnetization. The magnetization of the two sense ferromagnetic layers can be coupled in an anti-parallel direction due to the presence of an anti-parallel coupling layer.

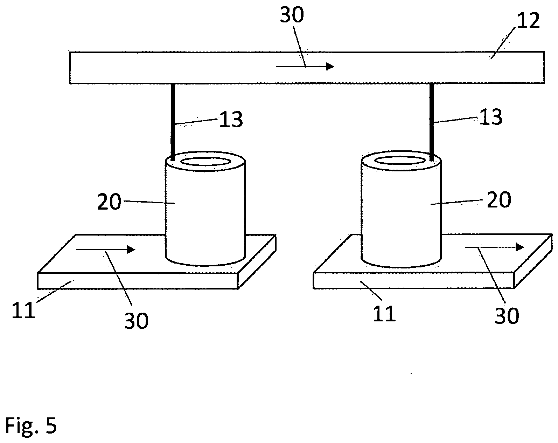

**Fig. 5** illustrates a magnetoresistive sensor device 10 comprising a plurality of the magnetoresistive elements 20, according to an embodiment. Fig. 3 shows only two magnetoresistive elements 20 but it should be understood that the magnetoresistive sensor device 10 can comprises more the two magnetoresistive elements 20. The magnetoresistive elements 20 can be electrically connected in series or in parallel. In the example of Fig. 3, the magnetoresistive elements 20 are electrically connected in series. In particular, one end of the magnetoresistive element 20 is connected to a first electrical connector 11 and the other end of the magnetoresistive element 20 is connected to a second electrical connector 12, for example through a via 13.

The magnitude of the external magnetic field 60 in the +z, -z direction can be measured by passing a sense current 30 in the magnetoresistive elements 20 of the magnetoresistive sensor device 10, through the first and second electrical connectors 11, 12 and the vias 13. The magnitude of the sense current 30 varies with the conductance (or resistance) of the magnetoresistive elements 20. The latter depends on the relative orientation of the sense magnetization 210 relative to the orientation of the reference magnetization 230 (see Fig. 1).

### Reference numbers and symbols

- 10: magnetoresistive sensor device
- 11: first electrical connector
- 12: second electrical connector
- 13: via
- 2: magnetoresistive sensor element
- 20: magnetic tunnel junction
- 201: interior part
- 202: exterior part
- 21: reference layer
- 210: reference magnetization
- 211: first reference sublayer
- 212: second reference sublayer
- 213: coupling layer
- 22: tunnel barrier layer
- 23: sense layer
- 230: sense magnetization
- 30: sense current
- 60: external magnetic field
- Dᵢₙₜ: inner diameter
- Dₒᵤₜ: outer diameter
- P_{L}: layer plane
- z: orthogonal direction
- +z: first orthogonal direction
- -z: second orthogonal direction

## Claims

1. Magnetoresistive element for sensing an external magnetic field, comprising:
a tunnel barrier layer (22) sandwiched between a ferromagnetic reference layer (21) having a pinned reference magnetization (210), and a ferromagnetic sense layer (23) having a sense magnetization (230) that can be freely oriented in the external magnetic field (60);
wherein the reference, tunnel barrier, and sense layers (21, 22, 23) are stacked perpendicular to a layer plane (P_{L}) thereof;
wherein the reference magnetization (210) is oriented substantially perpendicular to the layer plane (P_{L}), and the sense magnetization (230) is oriented substantially parallel to the layer plane (P_{L});
**characterized in that**
at least a portion of the magnetoresistive element (20) has an annular cross-section in the layer plane (P_{L}) forming an interior part (201) and an exterior part (202) of said at least a portion , the interior part (201) having an inner diameter (Dᵢₙₜ) and the exterior part (202) having an outer diameter (Dₒᵤₜ);
wherein said at least a portion comprises the sense layer (23), and wherein the sense magnetization (230) has a closed flux path configuration being orientable either in the clockwise or counterclockwise direction; and
wherein the inner diameter (Dᵢₙₜ) being larger than 300 nm, and a difference between the inner and outer diameters (Dᵢₙₜ, Dₒᵤₜ) is greater than 150 nm.

2. Magnetoresistive element according to claim 1,
wherein said at least a portion further comprises the reference layer (21).

3. Magnetoresistive element according to claim 1 or 2,
wherein said at least a portion further comprises the tunnel barrier layer (22).

4. Magnetoresistive element according to any one of claims 1 or 3,
wherein the outer diameter (Dₒᵤₜ) is between 500 nm and 5000 nm.

5. Magnetoresistive element according to any one of claims 1 or 4,
wherein the sense layer (23) has a thickness greater than 15 nm.

6. Magnetoresistive element according to any one of claims 1 or 5,
wherein the aspect ratio of the thickness to diameter of the sense layer (23) is between 0,005 and 2.

7. Magnetoresistive element according to any one of claims 1 or 6,
wherein the resistance-area-product (RA) of the magnetoresistive element (20) is higher than 50 ohm·µm².

8. Magnetoresistive element according to any one of claims 1 or 7,
wherein the interior part (201) has a substantially circular shape.

9. Magnetoresistive element according to any one of claims 1 or 7,
wherein the interior part (201) has a substantially elliptical shape.

10. Magnetoresistive element according to any one of claims 1 or 9,
wherein the interior part (201) is nonconcentric with the exterior part (202).

11. Magnetoresistive sensor device comprising a plurality of the magnetoresistive elements according to any one of claims 1 or 10, wherein the magnetoresistive elements are electrically connected in series or in parallel.

## Patentansprüche

1. Magnetoresistives Element zum Erfassen eines externen Magnetfelds, umfassend:
eine Tunnelbarriereschicht (22), die zwischen einer ferromagnetischen Referenzschicht (21) mit einer festen Referenzmagnetisierung (210) und einer ferromagnetischen Sensorschicht (23) mit einer Sensormagnetisierung (230) angeordnet ist, die in dem externen Magnetfeld (60) frei ausgerichtet werden kann;
wobei die Referenz-, Tunnelbarriere- und Sensorschichten (21, 22, 23) senkrecht zu einer Schichtebene (P_{L}) davon gestapelt sind;
wobei die Referenzmagnetisierung (210) im Wesentlichen senkrecht zu der Schichtebene (P_{L}) ausgerichtet ist und die Sensormagnetisierung (230) im Wesentlichen parallel zu der Schichtebene (P_{L}) ausgerichtet ist;
**dadurch gekennzeichnet, dass**
mindestens ein Abschnitt des magnetoresistiven Elements (20) in der Schichtebene (P_{L}) einen ringförmigen Querschnitt aufweist, der einen Innenteil (201) und einen Außenteil (202) des mindestens einen Abschnitts bildet, wobei der Innenteil (201) einen Innendurchmesser (Dᵢₙₜ) aufweist und der Außenteil (202) einen Außendurchmesser (Dₒᵤₜ) aufweist;
wobei der mindestens eine Abschnitt die Sensorschicht (23) umfasst und wobei die Sensormagnetisierung (230) eine geschlossene Flusspfadkonfiguration aufweist, die entweder im Uhrzeigersinn oder im Gegenuhrzeigersinn ausrichtbar ist; und
wobei der Innendurchmesser (Dᵢₙₜ) größer als 300 nm ist und eine Differenz zwischen dem Innen- und Außendurchmesser (Dᵢₙₜ, Dₒᵤₜ) größer als 150 nm ist.

2. Magnetoresistives Element nach Anspruch 1, wobei der mindestens eine Abschnitt ferner die Referenzschicht (21) umfasst.

3. Magnetoresistives Element nach Anspruch 1 oder 2, wobei der mindestens eine Abschnitt ferner die Tunnelbarriereschicht (22) umfasst.

4. Magnetoresistives Element nach einem der Ansprüche 1 oder 3, wobei der Außendurchmesser (Dₒᵤₜ) zwischen 500 nm und 5000 nm beträgt.

5. Magnetoresistives Element nach einem der Ansprüche 1 bis 4, wobei die Sensorschicht (23) eine Dicke von mehr als 15 nm aufweist.

6. Magnetoresistives Element nach einem der Ansprüche 1 oder 5, wobei das Aspektverhältnis der Dicke zu dem Durchmesser der Sensorschicht (23) zwischen 0,005 und 2 liegt.

7. Magnetoresistives Element nach einem der Ansprüche 1 oder 6, wobei das Widerstandsflächenprodukt (RA) des magnetoresistiven Elements (20) höher als 50 Ohm µm² ist.

8. Magnetoresistives Element nach einem der Ansprüche 1 oder 7, wobei der Innenteil (201) eine im Wesentlichen kreisförmige Form aufweist.

9. Magnetoresistives Element nach einem der Ansprüche 1 oder 7, wobei der Innenteil (201) eine im Wesentlichen elliptische Form aufweist.

10. Magnetoresistives Element nach einem der Ansprüche 1 oder 9, wobei der Innenteil (201) nicht konzentrisch mit dem Außenteil (202) ist.

11. Magnetoresistive Sensorvorrichtung, die mehrere der magnetoresistiven Elemente nach einem der Ansprüche 1 bis 10 umfasst, wobei die magnetoresistiven Elemente elektrisch in Serie oder parallel miteinander verbunden sind.

## Revendications

1. Élément magnétorésistif destiné à détecter un champ magnétique externe, comprenant :
une couche barrière tunnel (22) intercalée entre une couche ferromagnétique de référence (21) ayant une magnétisation de référence ancrée (210), et une couche de détection ferromagnétique (23) ayant une magnétisation de détection (230) qui peut être orientée librement dans le champ magnétique externe (60) ;
dans lequel les couches de référence, barrière tunnel, et de détection (21, 22, 23) sont empilées perpendiculairement à un plan de couche (P_{L}) de celles-ci ;
dans lequel la magnétisation de référence (210) est orientée sensiblement perpendiculairement au plan de couche (P_{L}), et la magnétisation de détection (230) est orientée sensiblement parallèlement au plan de couche (P_{L}) ;
**caractérisé en ce que**
au moins une portion de l'élément magnétorésistif (20) a une section transversale annulaire dans le plan de couche (P_{L}) formant une partie intérieure (201) et une partie extérieure (202) de ladite au moins une portion, la partie intérieure (201) ayant un diamètre interne (Dᵢₙₜ) et la partie extérieure (202) ayant un diamètre externe (Dₒᵤₜ) ;
dans lequel ladite au moins une portion comprend la couche de détection (23), et dans lequel la magnétisation de détection (230) a une configuration de trajet de flux fermé qui peut être orientée soit dans le sens des aiguilles d'une montre, soit dans le sens inverse des aiguilles d'une montre ; et
dans lequel le diamètre interne (Dᵢₙₜ) est supérieur à 300 nm, et une différence entre les diamètres interne et externe (Dᵢₙₜ, Dₒᵤₜ) est supérieure à 150 nm.

2. Élément magnétorésistif selon la revendication 1, dans lequel ladite au moins une portion comprend en outre la couche de référence (21).

3. Élément magnétorésistif selon la revendication 1 ou 2,
dans lequel ladite au moins une portion comprend en outre la couche barrière tunnel (22).

4. Élément magnétorésistif selon l'une quelconque des revendications 1 ou 3,
dans lequel le diamètre externe (Dₒᵤₜ) est compris entre 500 nm et 5000 nm.

5. Élément magnétorésistif selon l'une quelconque des revendications 1 ou 4,
dans lequel la couche de détection (23) a une épaisseur supérieure à 15 nm.

6. Élément magnétorésistif selon l'une quelconque des revendications 1 ou 5,
dans lequel le facteur de forme entre l'épaisseur et le diamètre de la couche de détection (23) est compris entre 0,005 et 2.

7. Élément magnétorésistif selon l'une quelconque des revendications 1 ou 6,
dans lequel le produit résistance-surface (RA) de l'élément magnétorésistif (20) est supérieur à 50 ohm·µm².

8. Élément magnétorésistif selon l'une quelconque des revendications 1 ou 7,
dans lequel la partie intérieure (201) a une forme sensiblement circulaire.

9. Élément magnétorésistif selon l'une quelconque des revendications 1 ou 7,
dans lequel la partie intérieure (201) a une forme sensiblement elliptique.

10. Élément magnétorésistif selon l'une quelconque des revendications 1 ou 9,
dans lequel la partie intérieure (201) est non concentrique à la partie extérieure (202).

11. Dispositif de capteur magnétorésistif comprenant une pluralité des éléments magnétorésistifs selon l'une quelconque des revendications 1 à 10, dans lequel les éléments magnétorésistifs sont connectés électriquement en série ou en parallèle.
